(19) Europäisches Patentamt / European Patent Office / Office européen des brevets

(11) **EP 3 485 713 B1**

(12) **EUROPÄISCHE PATENTSCHRIFT**

(45) Veröffentlichungstag und Bekanntmachung des Hinweises auf die Patenterteilung:
**09.03.2022   Patentblatt 2022/10**

(21) Anmeldenummer: **16753866.9**

(22) Anmeldetag: **03.08.2016**

(51) Internationale Patentklassifikation (IPC):
**H05K 13/08** (2006.01)

(52) Gemeinsame Patentklassifikation (CPC):
**H05K 13/085**

(86) Internationale Anmeldenummer:
**PCT/EP2016/068527**

(87) Internationale Veröffentlichungsnummer:
**WO 2018/024326 (08.02.2018 Gazette 2018/06)**

(54) **VERFAHREN UND VORRICHTUNG ZUR BESTIMMUNG DER MAXIMALEN ANZAHL AN KONSTANTEN TISCHEN IN EINER MEHRZAHL VON BESTÜCKUNGSLINIEN MIT BESTÜCKAUTOMATEN**

METHOD AND DEVICE FOR DETERMINING THE MAXIMUM NUMBER OF CONSTANT TABLES IN A PLURALITY OF PICK-AND-PLACE LINES HAVING PICK-AND-PLACE MACHINES

PROCÉDÉ ET DISPOSITIF DE DÉTERMINATION DU NOMBRE MAXIMAL DE TABLES CONSTANTES DANS UNE PLURALITÉ DE LIGNES DE MONTAGE DE COMPOSANTS AVEC DES AUTOMATES DE MONTAGE DE COMPOSANTS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**22.05.2019   Patentblatt 2019/21**

(73) Patentinhaber: **Siemens Aktiengesellschaft 80333 München (DE)**

(72) Erfinder:
• **PFAFFINGER, Alexander 81739 München (DE)**
• **ROYER, Christian 85521 Ottobrunn (DE)**

(56) Entgegenhaltungen:
**EP-A1- 2 409 556          WO-A1-2014/005744 DE-A1-102012 211 810**

EP 3 485 713 B1

**Beschreibung**

Die Erfindung betrifft ein Verfahren und eine Vorrichtung zur Bestimmung der maximal möglichen Anzahl an konstanten Tischen an Tischlokationen in einer Mehrzahl von Bestückungslinien mit Bestückautomaten, wobei die Rüstungen der konstanten Tische in allen Rüstfamilien verwendet werden.

Eine Rüstfamilie, auch Cluster genannt, umfasst eine Menge von Losen, die innerhalb einer Rüstung gefertigt werden kann. Damit ist gemeint, dass die Gesamtmenge der hierfür benötigten Bauelementtypen auf den der Linie zur Verfügung stehenden Tischlokationen untergebracht werden kann. Alle Baugruppen einer Rüstfamilie können also nacheinander ohne Umrüsten auf der Linie gefertigt werden.

Weiterhin betrifft die Erfindung eine Vorrichtung für eine Bestückungs- bzw. Fertigungs- oder Montagelinie zur Bestückung von Baugruppen mit Bauelementen. Außerdem betrifft die Erfindung ein Computerprogrammprodukt und ein computerlesbares Medium.

Insbesondere im Bereich der Elektronikproduktion werden zu fertigende Leiterplatten bzw. Baugruppen auf SMT-Bestückungslinien durch Oberflächenmontage (surface mounted technology, SMT) hergestellt. Ein Hersteller von SMT- Bestückautomaten und -systeme mit dem Produktnamen SIPLACE ist beispielsweise die Firma ASM (http://www.siplace.com/en/Home).

Mehrere Bestückautomaten, die üblicherweise durch ein Transportsystem verbunden sind, und die z.B. zum Fertigen von Elektronikteilen zusammenwirken, stellen eine Bestückungslinie dar.

Bei Bestückautomaten z.B. zum Bestücken von Baugruppen mit Bauelementen sind seitlich an einer Transportstrecke für die Baugruppe Zuführvorrichtungen für Bauelemente angeordnet. Ein durch ein Positioniersystem verfahrbarer Bestückkopf des Bestückautomaten holt die Bauelemente von den Zuführvorrichtungen ab, verfährt diese zu einem Bestückungsbereich des Bestückautomaten, in dem die zu bestückende Baugruppe bereitgestellt ist, und setzt die Bauelemente auf der Baugruppe ab. Für die Bereitstellung der Bauelemente werden z.B. sogenannte Gurt-Feeder eingesetzt, welche zum Transport und Zuführen von in Gurten gelagerten Bauelementen geeignet sind. Diese transportieren die in taschenartigen Vertiefungen magazinierten Bauteile zu einer Abholposition, an der die Bauelemente von dem Bestückkopf aus den Gurttaschen abgeholt werden. Der leere Gurt verlässt die Zuführvorrichtung an einer geeigneten Stelle.

Während des Bestückungsvorgangs steht die Leiterplatte bzw. Baugruppe bezüglich des Bestückungsautomaten üblicherweise still. Die Wechseltische umfassen jeweils eine Vielzahl Zuführungseinrichtungen. Jede Zuführungseinrichtung hält einen Vorrat von Bauelementen eines vorbestimmten Bauelementtyps bereit. Für die Bauelemente hat die Zuführungseinrichtung ein Fassungsvermögen (Platzkapazität), das üblicherweise in Spuren bzw. Spurkapazitäten ausgedrückt wird. Eine Spur ist üblicherweise 8 mm breit und die Zahl der Spuren jeder Zuführungseinrichtung ist beschränkt, beispielsweise auf 40. Bauelemente des gleichen Bauelementtyps sind üblicherweise bereitgestellt in einem Gurt, auf einem Tablett oder in einer Röhre. Jeder Bauelementtyp erfordert an der Zuführungseinrichtung eine vorbestimmte Anzahl Spuren, die üblicherweise aneinander angrenzen müssen.

Jede Zuführungseinrichtung kann zur Bereithaltung unterschiedlicher Bauelemente konfiguriert werden und üblicherweise können unterschiedliche Zuführungseinrichtungen an einem Wechseltisch angebracht werden. Wird ein Bauelement eines Bauelementtyps an einem bestimmten Bestückungsautomaten benötigt, der nicht in einem der Wechseltische vorhanden ist, so wird üblicherweise nicht einer der angebrachten Wechseltische mit den benötigten Bauelementen versehen, sondern komplett gegen einen anderen, entsprechend bestückten Wechseltisch ausgetauscht. Das Aufrüsten eines einzuwechselnden Wechseltischs mit Bauelementen 155 wird Vorrüstung genannt und kann eine Bearbeitungszeit im Stundenbereich erfordern.

Weiterhin ist es z.B. aus der Elektronikfertigung bekannt, die auf einer Bestückungslinie zu fertigenden Lose in Rüstfamilien zusammenzufassen. Alle Lose einer Rüstfamilie werden jeweils mit derselben Linienrüstung gefertigt. Konstante Tische sind dabei fest aufgestellte und fest gerüstete Tische, die für alle Rüstungen der Rüstfamilien identisch sind. Das Konzept der konstanten Tische reduziert den Umrüstaufwand und ermöglicht es Rüstequipment einzusparen.

Häufig werden die Fertigungen auch gemischt betrieben, wobei ein Teil der Baugruppen in der Fertigung mit konstanten Tischen und ein anderer Teil der Baugruppen in der Fertigung mit variabel rüstbaren bzw. variablen Tischen auf der gleichen Bestückungslinie produziert werden. Wegen des geringeren Aufwands für Planung, Lagerhaltung, Vorrüstung und Umrüstung wird allgemein angestrebt, den Anteil der konstanten Tische zu erhöhen und den Anteil der variablen Tische zu reduzieren.

Heutzutage werden die Rüstungen der konstanten Tische durch einen Produktionsplaner jeweils mit einer individuellen Strategie basierend auf der Erfahrung des Produktionsplaners und mehr oder weniger durch Ausprobieren (trial-and-error) ermittelt. Der damit verbundene zeitliche Aufwand ist sehr hoch und die Ergebnisse sind oft nicht zufrieden stellend.

Aus WO 2014/005744A1 ist ein Verfahren zur Zuordnung von Leitertplatten auf Bestücklinien bekannt. Die Zuordnung erfolgt derart, dass Bauteilevarianzen der Bestückungslinien möglichst gleich sind, wobei die Bauteilevarianz einer Bestückungslinie die Anzahl unterschiedlicher Bauteile repräsentiert, die auf allen der Bestückungslinien zugeordneten Leiterplatten zu bestücken sind. Dadurch können die Anzahlen von Rüstfamilien für die Bestückungslinien verbessert gleich gehalten werden.

Aus DE 10 2009 013 353 ist ein Verfahren zum Bestimmen von optimalen Bauelementrüstungen für konstante Tische von Bestückautomaten in Bestücklinien an fest vorgegebenen Tischlokationen bekannt, wobei die Rüstungen der konstanten Tische in allen Rüstfamilien verwendet werden, wobei eine Rüstfamilie hierbei eine Menge von Losen umfasst, die innerhalb einer Rüstung gefertigt werden.

Zu dieser Bestimmung von optimalen Bauelementrüstungen für konstante Tische kommt der Einsatz von mathematischen Optimierungsmethoden zum Tragen. Diese sind in der Regel lineare Optimierungsmethoden bzw. -verfahren. Die lineare Optimierung befasst sich mit der Optimierung linearer Zielfunktionen über einer Menge, die durch lineare Gleichungen und Ungleichungen eingeschränkt ist. Sie ist Grundlage der Lösungsverfahren der (gemischt-)ganzzahligen linearen Optimierung. Ein sogenannter Solver (Löser) ist eine Sammelbezeichnung für spezielle mathematische Computerprogramme, die mathematische Probleme numerisch lösen können. Im Zusammenhang mit MIP (mixed integer linear programming bzw. gemischt ganzzahlige Lineare Programmierung) können für kleine IP-Programme (ganzzahlige Optimierungsmodelle) Standardsolver wie z.B. CPLEX, Gurobi, I-log, Xpress verwendet werden.

Mit dem Verfahren lassen sich konstante Tischrüstungen an vorgegebenen Tischlokationen bestimmen. Diese Art der Bestimmung ist zur Berechnung der maximalen Anzahl an konstanten Tischen allerdings nicht geeignet, da dieses Verfahren bereits bei 10 Tischen mit 1023 Konfigurationen praktisch nicht mehr durchführbar und wenn doch, dann extrem rechenzeitintensiv ist.

Es ist Aufgabe der vorliegenden Erfindung, den oben genannten Stand der Technik zu verbessern, um dessen Nachteile zu überwinden.

Diese Aufgabe wird durch die unabhängigen Ansprüche gelöst.

Vorteilhafte Weiterbildungen sind Gegenstand der abhängigen Ansprüche.

Die Erfindung beansprucht ein Verfahren zur Bestimmung der maximal möglichen Anzahl an konstanten Tischen an Tischlokationen in einer oder mehreren Bestückungslinien zur Bestückung von Baugruppen mit Bauelementen mit Hilfe von Bestückautomaten, wobei die Rüstungen der konstanten Tische in allen Rüstfamilien einer Bestückungslinie verwendet werden, wobei eine Rüstfamilie eine Menge von Baugruppen umfasst, die mit einer gemeinsamen Bauelementrüstung auf einer Bestückungslinie produzierbar ist, und wobei die Gesamtmenge der hierfür benötigten Bauelementtypen auf den der Bestückungslinie zur Verfügung stehenden Tischlokationen untergebracht werden kann, wobei die maximal mögliche Anzahl an konstanten Tischen mittels Berechnung mit Hilfe von Gemischt Ganzzahliger Linearer Optimierung auf der Basis von die Bestückinfrastruktur beschreibenden Eingabedaten bestimmt wird, wobei die Bestückinfrastruktur insbesondere die Bestückungslinien mit den Bestückautomaten jeweils mit Bestückköpfen, zumindest einem Transportsystem für die Baugruppen, die genannten konstanten Tische und weitere variabel rüstbare Tische umfassen kann.

Als Eingabedaten werden folgende Daten verwendet:

- Menge der Bauelementtypen,
- Menge der Baugruppentypen,
- Menge der Bauelementtypen pro Baugruppentyp,
- Spurverbrauch pro Bauelementtyp,
- Maximale Spurkapazität pro Tisch,
- Menge der Tische einer Bestückungslinie,
- Menge der zulässigen Bauelementtypen pro Tisch.

Zur Berechnung der maximal möglichen Anzahl an konstanten Tischen können des Weiteren als vorgebbare Eingabeparameter folgende Parameter verwendet werden:

- der maximale Füllgrad für die konstanten Tische (KT1-KT4),
- der maximale Füllgrad für die variabel rüstbaren Tische (VT1-VT4).

Weiterhin werden erfindungsgemäss die Tische mit maximaler Gesamtspurkapazität (Summe der Spurkapazitäten) als konstante Tische ausgewählt. Dies bringt den Vorteil mit sich, dass bei berechneter maximaler Anzahl an konstanten Tischen bzw. wenn die maximale Anzahl an konstanten Tischen bestimmt ist, können die Tischlokationen mit den höchsten bzw. maximalen Spurkapazitäten verwendet werden.

Zur Berechnung der maximal möglichen Anzahl an konstanten Tischen (KT1-KT4) können als weitere Eingabedaten Minimalcluster vorgebbar sind, wobei Minimalcuster eine Menge Baugruppentypen umfasst, die zusammen in einer Rüstfamilie gefertigt werden müssen.

Ein Beispiel für Minimalcluster wäre, dass jeweils die Ober- und Unterseiten eines Leiterplattentyps zusammen in einem Cluster zu fertigen sind.

Ein weiterer Aspekt der Erfindung sieht eine Vorrichtung zur Bestimmung der maximal möglichen Anzahl an konstanten Tischen (KT1-KT4) an Tischlokationen in einer oder mehreren Bestückungslinien (BL) zur Bestückung von Baugruppen mit Bauelementen mit Hilfe von Bestückautomaten vor, wobei die Rüstungen der konstanten Tische in allen Rüstfamilien einer Bestückungslinie verwendet werden, wobei eine Rüstfamilie eine Menge von Baugruppen umfasst, die mit einer gemeinsamen Bauelementrüstung auf einer Bestückungslinie produzierbar ist, und wobei die Gesamtmenge der hierfür benötigten Bauelementtypen auf den der Bestückungslinie zur Verfügung stehenden Tischlokationen untergebracht werden kann, aufweisend:

- eine Bestückinfrastruktur, die insbesondere die Bestückungslinien mit den Bestückautomaten jeweils mit Bestückköpfen, zumindest einem Transportsystem für die Baugruppen, die genannten konstanten Tische und weitere variabel rüstbare Tische umfassen kann, und
- eine Berechnungseinheit, die dazu ausgelegt ist, die maximal möglichen Anzahl an konstanten Tischen mittels Berechnung mit Hilfe von Gemischt Ganzzahliger Linearer Optimierung auf der Basis von die Bestückinfrastruktur beschreibenden Eingabedaten zu bestimmen.

Die Vorrichtung kann Mittel und/oder Einheiten bzw. Einrichtungen und/oder Module zur Durchführung des oben genannten Verfahrens vorsehen, die jeweils hardwaremäßig und/oder firmwaremäßig und/oder softwaremäßig bzw. als Computerprogramm bzw. Computerprogrammprodukt ausgeprägt sein können.

Die Vorrichtung kann wie das oben beschriebene Verfahren entsprechend weitergebildet werden.

Ein weiterer Aspekt der Erfindung sieht eine Fertigungs- oder Montagelinienanordnung aufweisend eine solche erfindungsgemäße Vorrichtung vor.

Diese Fertigungs- oder Montagelinienanordnung kann Teil einer Anlage sein.

Die Anlage kann unter anderem durch einen der folgenden Anlagentypen charakterisiert sein. Beispiele hierfür sind:

- eine Automatisierungsanlage,
- eine Fertigungs- bzw. Produktionsanlage,
- eine Reinigungsanlage,
- eine Wasseraufbereitungsanlage,
- ein Gerät oder eine Maschine,
- eine Strömungsmaschine,
- eine Energieerzeugungsanlage,
- ein Energienetz,
- ein Kommunikationsnetz,
- eine medizintechnische Einrichtung bzw. Gerät,
- ein Krankenhausinformationssystem.

Ein weiterer Aspekt der Erfindung ist ein Computerprogrammprodukt bzw. ein Computerprogramm mit Mitteln zur Durchführung des oben genannten Verfahrens, wenn das Computerprogramm(-produkt) in einer oben genannten Vorrichtung oder in Mitteln der Vorrichtung zur Ausführung gebracht wird. Das Computerprogramm bzw. -produkt kann auf einem computerlesbaren Medium gespeichert sein. Das Computerprogramm bzw. -produkt kann in einer üblichen Programmiersprache (z.B. C++, Java) erstellt sein. Die Verarbeitungseinrichtung kann einen marktüblichen Computer oder Server mit entsprechenden Eingabe-, Ausgabe- und Speichermitteln umfassen. Diese Verarbeitungseinrichtung kann in der Vorrichtung oder in deren Mitteln integriert sein.

Weitere Vorteile, Einzelheiten und Weiterbildungen der Erfindung ergeben sich aus der nachfolgenden Beschreibung von Ausführungsbeispielen in Verbindung mit der Zeichnung.

Dabei zeigt
die Figur eine beispielhafte Ausgestaltung einer Bestückungslinie mit zwei Bestückautomaten.

Der Bestückautomat BA1 besteht aus vier Fördertischen KT1,KT2,VT1,VT2 von denen zwei variable Tische VT1,VT2 und zwei konstante Tische KT1,KT2 sind. Weiterhin besteht der Bestückautomat BA1 aus vier Bestückköpfen BK1-BK4 jeweils vom Typ CP20. Die Bestückköpfe BK1-BK8 eines Bestückautomaten BA1, BA2 holen die Bauelemente von den Zuführvorrichtungen ZE1,ZE2 ab und verfahren diese zu einem Bestückbereich des Bestückautomaten BA1,BA2, wo die zu bestückende Baugruppe (z.B. eine Grundplatte bei SMD Fertigung) bereitgestellt ist, und setzt die Bauelemente auf der Baugruppe ab. Die Bestückköpfe BK1-BK8 sind üblicherweise durch ein Positioniersystem verfahrbar. Als Zuführvorrichtungen ZE1,ZE2 für die Bereitstellung der Bauelemente können z.B. sogenannte Gurt-Feeder eingesetzt werden.

Ebenfalls am Transportsystem TS, welches die Grundplatte bereitstellt, angeordnet ist der Bestückautomat BA2 mit zwei variable Tischen VT3,VT4 und zwei konstanten Tischen KT3,KT4. Weiterhin besteht der Bestückautomat

BA2 aus vier Bestückköpfen BK5-BK8 jeweils vom Typ CP12.

In der Figur ist beispielhaft dargestellt, dass die variablen Tische VT2 und VT4 Zuführvorrichtungen ZE1 bzw. ZE2 aufweisen, zum Bereitstellen der zu bestückenden Bauelemente (z.B. Chips, Transistoren etc.).

In der SMD Fertigung (z.B. für elektronische Komponenten) werden für die Bestückung von Leiterplatten (Baugruppen) Bestückautomaten BA1,BA2 verwendet, die Bauelemente aus Zuführvorrichtungen ZE1,ZE2 mit Hilfe eines Bestückkopfes BK1-BK8 auf die Leiterplatten setzen. Die Leiterplatten (Boards) werden an den Bestückautomaten BA1,BA2 durch das Transportsystem TS bereitgestellt.

Üblicherweise (z.B. In der Elektronikfertigung) werden die auf einer Bestückungslinie zu fertigenden Lose in Rüstfamilien zusammengefasst. Alle Lose einer Rüstfamilie werden jeweils mit derselben Linienrüstung gefertigt.

Konstante Tische KT1-KT4 sind fest aufgestellte und fest gerüstete Tische, die für alle Rüstungen der Rüstfamilien (Cluster) identisch sind. Damit lässt sich Umrüstaufwand für das mit variablen Rüstungen gefertigte Produktionsvolumen reduzieren und Rüstequipment einsparen.

Unter einem variablen Tisch VT1-VT4 versteht man einen einer Stationsseite eines Bestückautomaten zugeordneten Wechsel- bzw. Fördertisch, bei dem die Rüstungen nicht für alle Rüstfamilien konstant sein müssen, sondern variieren, d.h. verändert werden können. Variable Tische VT1-VT4 müssen je nach Bedarf ausgetauscht werden. Dies bedeutet Umrüstaufwand. Weiterhin werden variable Tische VT1-VT4 zum Wechseln bereitgehalten. Dies verursacht einen hohen Bedarf an Lagerraum.

Das Verfahren zur Bestimmung der maximal möglichen Anzahl an konstanten Tischen KT1-KT4 basiert auf der mathematischen Methode der Ganzzahligen Linearen Optimierung (Integer Linear Programming) bzw. der Gemischt Ganzzahligen Linearen Optimierung (Mixed Integer Linear Programming, MIP).

Im Folgenden werden als mathematische Optimierungsmethode (lineare) IP-Modelle (IP steht für Integer Programmierung bzw. für Integer Programm oder ganzzahliges Optimierungsmodell) bzw. MIP-Modelle (Gemischt Ganzzahligen Linearen Optimierung (Mixed Integer Linear Programming)) für diese Problemstellung beschrieben. Durch den Einsatz von exakten mathematischen Verfahren lassen sich deutlich bessere Lösungen erzielen als mit bisher verwendeten Heuristiken bzw. Optimierungsmethoden. IP-Lösungsansätze weisen folgende Vorteile auf:

- Globaler Optimierungsansatz.
- Leicht erweiterbar.
- Sehr gute kommerzielle Standard-Solver (z.B. Ilog, Gurobi), die in der Praxis weit verbreitet und bewährt sind.
- Die Standard-Solver werden laufend verbessert, so dass zu erwarten ist das die Instanzen in Zukunft noch schneller lösbar sind.

Die maximale Anzahl an konstanten Tischen in einer Mehrzahl von Bestückungslinien mit Bestückautomaten kann mit einer in der Figur nicht dargestellten Einheit ermittelt bzw. bestimmt werden. Eine solche Einheit kann in einen Bestückautomaten z.B. BA1 der Bestückungslinie BL integriert sein. Diese Einheit kann auch in einen separiert von den Bestückautomaten stehenden Computer implementiert bzw. integriert sein, der die Bestückautomaten steuert.

Das dargestellte IP-Modell ist nur als eine mögliche beispielhafte Formulierung anzusehen und stellt keine Einschränkung für das Verfahren dar.

Das Zielkriterium wird durch einen linearen Ausdruck formuliert, der zu maximieren oder zu minimieren ist.

Im Ausführungsbeispiel werden folgende Eingabedaten bzw. Eingabeparameter im IP-Modell verwendet: Es werden Gemischt-Ganzzahlige-Lineare Optimierungsmodelle (MIP, Mixed Integer Linear Program) vorgeschlagen, mit denen die Anzahl der maximal möglichen konstanten Tische bzw. deren maximale Gesamtspurkapazität sehr schnell und exakt abschätzbar sind.

In der MIP-Formulierung gelten die folgenden Bezeichnungen:

Indices

| | |
|---|---|
| C | Menge der Bauelementtypen |
| R | Menge der Baugruppentypen |
| $R_C$ | Menge der Baugruppen mit Bauelementtyp c |

Parameter

| | |
|---|---|
| $Width_c$ | Platzverbrauch eines Bauelementtyps c |
| Cap | Linienkapazität an Spuren |

Binärvariablen

SetupConst$_c$    Variable, die angibt, ob der Bauelementtyp c auf den konstanten Tischen gerüstet wird. In diesem Fall nimmt sie den Wert 1 an, anderenfalls den Wert 0.

SetupVar$_{c,r}$    Variable, die angibt, ob der Bauelementtyp c im variablen Rüstanteil für den Baugruppentyp r gerüstet wird. In diesem Fall nimmt sie den Wert 1 an, anderenfalls den Wert 0.

Schätzer für die maximale Gesamtspurkapazität der konstanten Tische:
Kontinuierliche Variablen:

CapVar$_r$    Spurbedarf für den variablen Rüstanteil des Baugruppentyps r
CapConst    Gesamtspurkapazität der konstanten Tische

maximize CapConst
Unter der Bedingung:

(1) SetupConst$_c$ + SetupVar$_{r,c}$ = 1                    $c \in C, r \in R_c$
(2) CapConst + CapVar$_r \leq$ Cap                           $r \in R$
                                                            $r \in R$

(3) $\sum_{c \in C}$ Width$_c$SetupVar$_{c,r} \leq$ CapVar$_r$

(4) $\sum_{c \in C}$ Width$_c$SetupConst$_c \leq$ CapConst

SetupConst$_c \in \{0,1\}$                    $c \in C$
SetupVar$_{c,r} \in \{0,1\}$                  $c \in C, r \in R_c$
CapVar$_r \geq 0$                             $r \in R$
CapConst $\geq 0$

Zu (1): Für einen Baugruppentyp müssen sich alle enthaltenen Bauelementtypen entweder im konstanten Rüstanteil oder im variablen Rüstanteil befinden.
Zu (2): Die Summe der Gesamtspurkapazitäten für den konstanten Rüstanteil und für einen variablen Rüstanteil darf die Linienkapazität nicht überschreiten.
Zu (3): Die Summe der Spurbreiten der Bauelementtypen im variablen Rüstanteil eines Baugruppentyps darf dessen Kapazität nicht überschreiten.
Zu (4): Die Summe der Spurbreiten der Bauelementtypen im konstanten Rüstanteil darf dessen Kapazität nicht überschreiten.

Schätzung der maximalen Anzahl der konstanten Tische mit Einzeltisch-Sicht:
Zusätzliche Indices:

$T$    Menge der Tische der Linie.
$C_t$    Menge der Bauelementtypen, die an Tisch t gerüstet werden dürfen, d. h. Bauelementtypen, die von einem Kopf der auf diesen Tisch zugreift, gesetzt werden können.

Zusätzliche Parameter:
Cap$_t$ Platzkapazität von Tisch t
Zusätzliche Binärvariablen:

IsConst$_t$    Variable die angibt, ob ein Tisch konstant ist.
SetupConst$_{c,t}$    Variable, die angibt ob der Bauelementtyp c auf den konstanten Tischen t gerüstet wird. In diesem Fall nimmt sie den Wert 1 an, anderenfalls den Wert 0.
SetupVar$_{c,r,t}$    Variable, die angibt ob der Bauelementtyp c im variablen Rüstanteil für die Baugruppe r auf dem Tisch t gerüstet wird. In diesem Fall nimmt sie den Wert 1 an, anderenfalls den Wert 0.

$$\mathrm{m} \qquad \mathrm{aximize} \sum_{t \in T} \mathrm{IsConst}_t$$

unter der Bedingung:

(1) $\displaystyle\sum_{t \in T} \mathrm{SetupConst}_{c,t} + \mathrm{SetupVar}_{c,r,t} = 1$ $\qquad\qquad\qquad c \in C, r \in R_c$

(2) $\displaystyle\sum_{c \in C} \mathrm{Width}_c \, \mathrm{SetupVar}_{c,r,t} \le \mathrm{Cap}_t$ $\qquad\qquad\qquad r \in R, t \in T$

(3) $\displaystyle\sum_{c \in C} \mathrm{Width}_c \, \mathrm{SetupConst}_{c,t} \le \mathrm{Cap}_t$ $\qquad\qquad\qquad t \in T$

(4) $\mathrm{SetupConst}_{c,t} \le \mathrm{IsConst}_t$ $\qquad\qquad\qquad\qquad\qquad c \in C, t \in T$

(5) $\mathrm{SetupVar}_{c,r,t} \le (1 - \mathrm{IsConst}_t)$ $\qquad\qquad\qquad\quad t \in T$

(6) $\mathrm{SetupConst}_{c,t} = 0$ $\qquad\qquad\qquad\qquad\qquad\qquad\quad t \in T, c \in C \setminus C_t$

(7) $\mathrm{SetupVar}_{c,r,t} = 0$ $\qquad\qquad\qquad\qquad\qquad\qquad r \in R, t \in T, c \in C \setminus C_t$

$\mathrm{SetupConst}_{c,t} \in \{0,1\}$ $\qquad\qquad\qquad\qquad\qquad t \in T, c \in C$

$\mathrm{SetupVar}_{c,r,t} \in \{0,1\}$ $\qquad\qquad\qquad\qquad\qquad r \in R, t \in T, c \in C$

$\mathrm{IsConst}_t \in \{0,1\}$ $\qquad\qquad\qquad\qquad\qquad\qquad\quad t \in T$

Zu (1): Für einen Baugruppentyp müssen sich alle enthaltenen Bauelementtypen entweder auf einem konstanten Tisch oder einem variablen Tisch befinden.

Zu (2): Die Summe der Spurbreiten der Bauelementtypen auf einem variablen Tisch darf dessen Kapazität nicht überschreiten.

Zu (3): Die Summe der Spurbreiten der Bauelementtypen auf einem konstanten Tisch darf dessen Kapazität nicht überschreiten.

Zu (4): Auf konstanten Tischen dürfen nur konstant gerüstete Bauelementtypen.

Zu (5): Auf variablen Tischen dürfen nur variabel gerüstete Bauelementtypen.

Zu (6), (7): Auf Tischen dürfen nur dort zulässige Bauelementtypen gerüstet werden.

Es sind folgende ergänzende Ausprägungen möglich:

- Berücksichtigung von Füllgraden der variablen und konstanten Tische.
- Anstatt der Baugruppentypen kann man auch Minimalcluster von Baugruppentypen verwenden (z.B. die Ober- und Unterseite einer Baugruppe, Teilmenge der Baugruppen, die in dasselbe Cluster zuzuordnen ist).
- Die Schätzer lassen sich auch auf "fertige" oder "teilweise fertige" Clusterungen anwenden. So ist z.B. ein Clusterverfahren mit den kombinierten Zielen "geringe Anzahl an Cluster" und "maximale Anzahl an konstanten Tischen" denkbar.
- Maximaler Füllgrad einer Festrüstung (ausgedrückt in Prozent), d.h. der Platzverbrauch der Bauelementtypen der Festrüstung darf nur diesen Prozentsatz der gesamten Linienkapazität betragen.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

Die Implementierung der vorstehend beschriebenen Prozesse oder Verfahrensabläufe kann anhand von Instruktionen erfolgen, die auf computerlesbaren Speichermedien oder in flüchtigen Computerspeichern (im Folgenden zusammenfassend als computerlesbare Speicher bezeichnet) vorliegen. Computerlesbare Speicher sind beispielsweise flüchtige Speicher wie Caches, Puffer oder RAM sowie nichtflüchtige Speicher wie Wechseldatenträger, Festplatten, usw.

Die vorstehend beschriebenen Funktionen oder Schritte können dabei in Form zumindest eines Instruktionssatzes in/auf einem computerlesbaren Speicher vorliegen. Die Funktionen oder Schritte sind dabei nicht an einen bestimmten Instruktionssatz oder an eine bestimmte Form von Instruktionssätzen oder an ein bestimmtes Speichermedium oder an einen bestimmten Prozessor oder an bestimmte Ausführungsschemata gebunden und können durch Software, Firmware, Microcode, Hardware, Prozessoren, integrierte Schaltungen usw. im Alleinbetrieb oder in beliebiger Kombination ausgeführt werden. Dabei können verschiedenste Verarbeitungsstrategien zum Einsatz kommen, beispielsweise serielle Verarbeitung durch einen einzelnen Prozessor oder Multiprocessing oder Multitasking oder Parallelverarbeitung usw.

Die Instruktionen können in lokalen Speichern abgelegt sein, es ist aber auch möglich, die Instruktionen auf einem entfernten System abzulegen und darauf via Netzwerk zuzugreifen.

Der Begriff "Prozessor", "zentrale Signalverarbeitung", "Steuereinheit" oder "Datenauswertemittel", wie hier verwendet, umfasst Verarbeitungsmittel im weitesten Sinne, also beispielsweise Server, Universalprozessoren, Grafikprozessoren, digitale Signalprozessoren, anwendungsspezifische integrierte Schaltungen (ASICs), programmierbare Logikschaltungen wie FPGAs, diskrete analoge oder digitale Schaltungen und beliebige Kombinationen davon, einschließlich aller anderen dem Fachmann bekannten oder in Zukunft entwickelten Verarbeitungsmittel. Prozessoren können dabei aus einer oder mehreren Vorrichtungen bzw. Einrichtungen bzw. Einheiten bestehen. Besteht ein Prozessor aus mehreren Vorrichtungen, können diese zur parallelen oder sequentiellen Verarbeitung bzw. Ausführung von Instruktionen ausgelegt bzw. konfiguriert sein.

## Patentansprüche

1. Verfahren zur Bestimmung der maximal möglichen Anzahl an konstanten Tischen (KT1-KT4) an Tischlokationen in einer oder mehreren Bestückungslinien (BL) zur Bestückung von Baugruppen mit Bauelementen mit Hilfe von Bestückautomaten (BA1,BA2), wobei die Rüstungen der konstanten Tische (KT1-KT4) in allen Rüstfamilien einer Bestückungslinie verwendet werden, wobei eine Rüstfamilie eine Menge von Baugruppen umfasst, die mit einer gemeinsamen Bauelementrüstung auf einer Bestückungslinie produzierbar ist, und wobei die Gesamtmenge der hierfür benötigten Bauelementtypen auf den der Bestückungslinie zur Verfügung stehenden Tischlokationen untergebracht werden kann, **dadurch gekennzeichnet, dass** die maximal mögliche Anzahl an konstanten Tischen (KT1-KT4) mittels Berechnung mit Hilfe von Gemischt Ganzzahliger Linearer Optimierung auf der Basis von die Bestückinfrastruktur (BL,BA1,BA2,TS,KT1-KT4,VT1-VT4,BK1-BK8) beschreibenden Eingabedaten bestimmt wird, wobei die Bestückinfrastruktur insbesondere die Bestückungslinien (BL) mit den Bestückautomaten (BA1, BA2) jeweils mit Bestückköpfen (KT1-KT4), zumindest einem Transportsystem (TS) für die Baugruppen, die genannten konstanten Tische und weitere variabel rüstbare Tische umfassen kann, wobei als Eingabedaten folgende Daten verwendet werden:

   - Menge der Bauelementtypen,
   - Menge der Baugruppentypen,
   - Menge der Bauelementtypen pro Baugruppentyp,
   - Spurverbrauch pro Bauelementtyp,
   - Maximale Spurkapazität pro Tisch,
   - Menge der Tische einer Bestückungslinie,
   - Menge der zulässigen Bauelementtypen pro Tisch, und wobei die Tische mit maximaler Gesamtspurkapazität, das heisst mit der maximalen Summe der Spurkapazitäten, als konstante Tische ausgewählt werden.

2. Verfahren nach Anspruch 1, **dadurch gekennzeichnet, dass** zur Berechnung der maximalen Anzahl an konstanten Tischen (KT1-KT4) des Weiteren als vorgebbare Eingabeparameter folgende Parameter verwendet werden:

   - der maximale Füllgrad für die konstanten Tische (KT1-KT4) ;
   - der maximale Füllgrad für die variabel rüstbaren Tische (VT1-VT4).

3. Verfahren nach einem der vorstehenden Ansprüche, **dadurch gekennzeichnet, dass** zur Berechnung der maximalen Anzahl an konstanten Tischen (KT1-KT4) als weitere Eingabedaten Minimalcluster vorgebbar sind, wobei ein Minimalcuster eine Menge Baugruppentypen umfasst, die zusammen in einer Rüstfamilie gefertigt werden müssen.

4. Vorrichtung zur Bestimmung der maximal möglichen Anzahl an konstanten Tischen (KT1-KT4) an Tischlokationen in einer oder mehreren Bestückungslinien (BL) zur Bestückung von Baugruppen mit Bauelementen mit Hilfe von Bestückautomaten (BA1,BA2), wobei die Rüstungen der konstanten Tische (KT1-KT4) in allen Rüstfamilien einer Bestückungslinie verwendet werden, wobei eine Rüstfamilie eine Menge von Baugruppen umfasst, die mit einer gemeinsamen Bauelementrüstung auf einer Bestückungslinie produzierbar ist, und wobei die Gesamtmenge der hierfür benötigten Bauelementtypen auf den der Bestückungslinie zur Verfügung stehenden Tischlokationen untergebracht werden kann, aufweisend:

- eine Bestückinfrastruktur, die insbesondere die Bestückungslinien (BL) mit den Bestückautomaten (BA1, BA2) jeweils mit Bestückköpfen (KT1-KT4), zumindest einem Transportsystem (TS) für die Baugruppen, die genannten konstanten Tische und weitere variabel rüstbare Tische umfassen kann, und
- eine Berechnungseinheit, die dazu ausgelegt ist, die maximal mögliche Anzahl an konstanten Tischen (KT1-KT4) mittels Berechnung mit Hilfe von Gemischt Ganzzahliger Linearer Optimierung auf der Basis von die Bestückinfrastruktur (BL,BA1,BA2,TS,KT1-KT4,VT1-VT4,BK1-BK8) beschreibenden Eingabedaten zu bestimmen, wobei als Eingabedaten folgende Daten verwendbar sind:
- Menge der Bauelementtypen,
- Menge der Baugruppentypen,
- Menge der Bauelementtypen pro Baugruppentyp,
- Spurverbrauch pro Bauelementtyp,
- Maximale Spurkapazität pro Tisch,
- Menge der Tische einer Bestückungslinie,
- Menge der zulässigen Bauelementtypen pro Tisch, und wobei die Tische mit maximaler Gesamtspurkapazität , das heisst mit der maximalen Summe der Spurkapazitäten, als konstante Tische ausgewählt werden.

5. Vorrichtung nach Anspruch 4, **dadurch gekennzeichnet, dass** zur Berechnung der maximalen Anzahl an konstanten Tischen (KT1-KT4) des Weiteren als vorgebbare Eingabeparameter folgende Parameter verwendbar sind:

- der maximale Füllgrad für die konstanten Tische (KT1-KT4);
- der maximale Füllgrad für die variabel rüstbaren Tische (VT1-VT4) .

6. Vorrichtung nach einem der vorstehenden Vorrichtungsansprüche, **dadurch gekennzeichnet, dass** zur Berechnung der maximalen Anzahl an konstanten Tischen (KT1-KT4) als weitere Eingabedaten Minimalcluster Baugruppentypen vorgebbar sind, wobei ein Minimalcuster eine Menge Baugruppentypen umfasst, die zusammen in einer Rüstfamilie zu fertigen sind.

7. Fertigungs- oder Montagelinie aufweisend eine Vorrichtung nach einem der vorstehenden Vorrichtungsansprüche.

8. Computerprogramm mit Mitteln zur Durchführung des Verfahrens nach einem der vorgenannten Verfahrensansprüche, wenn das Computerprogramm auf einer Vorrichtung nach einem der vorgenannten Vorrichtungsansprüche zur Ausführung gebracht wird.

9. Computerlesbares Medium, umfassend Anweisungen, welche, wenn sie auf der Vorrichtung nach einem der vorhergehenden Vorrichtungsansprüche ausgeführt werden, die Vorrichtung dazu bringen, das Verfahren gemäß einem der vorhergehenden Verfahrensansprüche auszuführen.

## Claims

1. Method for determining the maximum possible number of constant tables (KT1-KT4) at table locations in one or more pick-and-place lines (BL) for the placement of components on assemblies with the aid of pick-and-place machines (BA1, BA2), wherein the fittings on the constant tables (KT1-KT4) are used in all the fitting families of a pick-and-place line, wherein a fitting family comprises a set of assemblies which can be produced on a pick-and-place line with a common component fitting, and wherein the entire set of component types required for this purpose can be accommodated on the table locations available to the pick-and-place line, **characterized in that** the maximum possible number of constant tables (KT1-KT4) is determined by means of calculation with the aid of mixed integer linear optimization on the basis of input data describing the pick-and-place infrastructure (BL, BA1, BA2, TS, KT1-KT4, VT1-VT4, BK1-BK8), wherein the pick-and-place infrastructure can comprise in particular the pick-and-place lines (BL) having the pick-and-place machines (BA1, BA2), each having pick-and-place heads (KT1-KT4), at least one transport system (TS) for the assemblies, said constant tables and further tables which can be variably fitted, wherein the following data are used as input data:

- set of component types,
- set of assembly types,

- set of component types per assembly type,
- track occupation per component type,
- maximum track capacity per table,
- set of tables of a pick-and-place line,
- set of permissible component types per table,

and wherein the tables with maximum total track capacity, i.e. with the maximum sum of the track capacities, are selected as constant tables.

2. Method according to Claim 1, **characterized in that** the following parameters are furthermore used as predefinable input parameters for calculating the maximum number of constant tables (KT1-KT4):

- the maximum degree of filling for the constant tables (KT1-KT4);
- the maximum degree of filling for the tables (VT1-VT4) which can be variably fitted.

3. Method according to either of the preceding claims, **characterized in that** minimum clusters are predefinable as further input data for calculating the maximum number of constant tables (KT1-KT4), wherein a minimum cluster comprises a set of assembly types which have to be produced together in a fitting family.

4. Device for determining the maximum possible number of constant tables (KT1-KT4) at table locations in one or more pick-and-place lines (BL) for the placement of components on assemblies with the aid of pick-and-place machines (BA1, BA2), wherein the fittings on the constant tables (KT1-KT4) are used in all the fitting families of a pick-and-place line, wherein a fitting family comprises a set of assemblies which can be produced on a pick-and-place line with a common component fitting, and wherein the entire set of component types required for this purpose can be accommodated on the table locations available to the pick-and-place line, comprising:

- a pick-and-place infrastructure, which can comprise in particular the pick-and-place lines (BL) having the pick-and-place machines (BA1, BA2), each having pick-and-place heads (KT1-KT4), at least one transport system (TS) for the assemblies, said constant tables and further tables which can be variably fitted, and
- a calculation unit designed to determine the maximum possible number of constant tables (KT1-KT4) by means of calculation with the aid of mixed integer linear optimization on the basis of input data describing the pick-and-place infrastructure (BL, BA1, BA2, TS, KT1-KT4, VT1-VT4, BK1-BK8), wherein the following data are usable as input data:
- set of component types,
- set of assembly types,
- set of component types per assembly type,
- track occupation per component type,
- maximum track capacity per table,
- set of tables of a pick-and-place line,
- set of permissible component types per table,

and wherein the tables with maximum total track capacity, i.e. with the maximum sum of the track capacities, are selected as constant tables.

5. Device according to Claim 4, **characterized in that** the following parameters are furthermore usable as predefinable input parameters for calculating the maximum number of constant tables (KT1-KT4):

- the maximum degree of filling for the constant tables (KT1-KT4);
- the maximum degree of filling for the tables (VT1-VT4) which can be variably fitted.

6. Device according to either of the preceding device claims, **characterized in that** minimum clusters of assembly types are predefinable as further input data for calculating the maximum number of constant tables (KT1-KT4), wherein a minimum cluster comprises a set of assembly types which are to be produced together in a fitting family.

7. Production or mounting line comprising a device according to any of the preceding device claims.

8. Computer program comprising means for carrying out the method according to any of the preceding method claims when the computer program is executed on a device according to any of the preceding device claims.

9. Computer-readable medium comprising instructions which, when they are executed on the device according to any of the preceding device claims, cause the device to perform the method according to any of the preceding method claims.

**Revendications**

1. Procédé de détermination du nombre maximal possible de tables constantes (KT1-KT4) à des positions de table dans une ou plusieurs lignes de montage de composants (BL) pour l'assemblage de modules avec des composants à l'aide d'automates de montage de composants (BA1,BA2), les équipements des tables constantes (KT1-KT4) étant utilisés dans toutes les familles d'équipement d'une ligne de montage de composants, une famille d'équipement comprenant une quantité de modules pouvant être produite avec un équipement de composant commun sur une ligne de montage de composants, et la quantité totale des types de composants nécessaires à cet effet peut être logée sur les positions de table disponibles pour la ligne de montage de composants, **caractérisé en ce que** le nombre maximal possible de tables constantes (KT1-KT4) est déterminé par un calcul utilisant une optimisation linéaire mixte en nombres entiers sur la base de données d'entrée décrivant l'infrastructure de montage de composants (BL, BA1, BA2, TS, KT1-KT4, VT1-VT4, BK1-BK8), l'infrastructure de montage de composants pouvant comprendre en particulier les lignes de montage de composants (BL) dotées des automates de montage de composants (BA1, BA2) ayant chacun une tête de montage de composants (KT1-KT4), et d'au moins un système de transport (TS) pour les modules, lesdites tables constantes et d'autres tables pouvant être équipées de manière variable, les données suivantes étant utilisées comme données d'entrée :

   - quantité de types de composants,
   - quantité de types de modules,
   - quantité de types de composants par type de module,
   - utilisation de piste par type de composant,
   - capacité de piste maximale par table,
   - quantité de tables dans une ligne de montage de composants,
   - nombre de types de composants autorisés par table, et les tables ayant la capacité de piste totale maximale, c'est-à-dire la somme maximale des capacités de piste, étant choisies comme tables constantes.

2. Procédé selon la revendication 1, **caractérisé en ce que** les paramètres suivants sont également utilisés comme paramètres d'entrée pouvant être prédéfinis pour calculer le nombre maximal de tables constantes (KT1-KT4) :

   - le taux de remplissage maximal pour les tables constantes (KT1-KT4) ;
   - le taux de remplissage maximal pour les tables pouvant être équipées de manière variable (VT1-VT4).

3. Procédé selon l'une des revendications précédentes, **caractérisé en ce que** pour calculer le nombre maximal de tables constantes (KT1-KT4), des clusters minimaux peuvent être prédéfinis comme données d'entrée supplémentaires, un cluster minimal comprenant une certaine quantité de types de modules qui doivent être fabriqués ensemble dans une même famille d'équipement.

4. Dispositif de détermination du nombre maximal possible de tables constantes (KT1-KT4) à des positions de table dans une ou plusieurs lignes de montage de composants (BL) pour l'assemblage de modules avec des composants à l'aide d'automates de montage de composants (BA1, BA2), les équipements des tables constantes (KT1-KT4) étant utilisés dans toutes les familles d'équipement d'une ligne de montage de composants, une famille d'équipement comprenant une quantité de modules pouvant être produite avec un équipement de composant commun sur une ligne de montage de composants, et la quantité totale des types de composants nécessaires à cet effet peut être logée sur les positions de table disponibles pour la ligne de montage de composants, le dispositif comportant :

   - une infrastructure de montage de composants, qui peut comprendre en particulier les lignes de montage de composants (BL) dotées des automates de montage de composants (BA1, BA2) ayant chacun une tête de montage de composants (KT1-KT4), et d'au moins un système de transport (TS) pour les modules, lesdites tables constantes et d'autres tables pouvant être équipées de manière variable, et
   - une unité de calcul qui est conçue pour déterminer le nombre maximum possible de tables constantes (KT1-KT4) par un calcul utilisant une optimisation linéaire mixte en nombres entiers sur la base de données d'entrée décrivant l'infrastructure de montage de composants (BL, BA1, BA2, TS, KT1-KT4, VT1-VT4, BK1-BK8), les données suivantes pouvant être utilisées comme données d'entrée :

- quantité de types de composants,
- quantité de types de modules,
- quantité de types de composants par type de module,
- utilisation de piste par type de composant,
- capacité de piste maximale par table,
- quantité de tables dans une ligne de montage de composants,
- quantité de types de composants autorisés par table, et les tables ayant la capacité de piste totale maximale, c'est-à-dire la somme maximale des capacités de piste, étant choisies comme tables constantes.

5. Dispositif selon la revendication 4, **caractérisé en ce que** les paramètres suivants sont également utilisables comme paramètres d'entrée pouvant être prédéfinis pour calculer le nombre maximal de tables constantes (KT1-KT4) :

- le taux de remplissage maximal pour les tables constantes (KT1-KT4) ;
- le taux de remplissage maximal pour les tables pouvant être équipées de manière variable (VT1-VT4).

6. Dispositif selon l'une des revendications de dispositif précédentes, **caractérisé en ce que**, pour calculer le nombre maximal de tables constantes (KT1-KT4), des clusters minimaux de types de module peuvent être prédéfinis comme données d'entrée supplémentaires, un cluster minimal comprenant une certaine quantité de types de modules qui doivent être fabriqués ensemble dans une famille d'équipement.

7. Ligne de fabrication ou de montage comportant un dispositif selon l'une des revendications de dispositif précédentes.

8. Programme informatique doté de moyens pour la mise en œuvre du procédé selon l'une des revendications de procédé susmentionnées, lorsque le programme informatique est exécuté sur un dispositif selon l'une des revendications de dispositif susmentionnées.

9. Support lisible par ordinateur comprenant des instructions qui, lorsqu'elles sont exécutées sur le dispositif selon l'une des revendications de dispositif précédentes, amènent le dispositif à exécuter le procédé selon l'une des revendications de procédé précédentes.

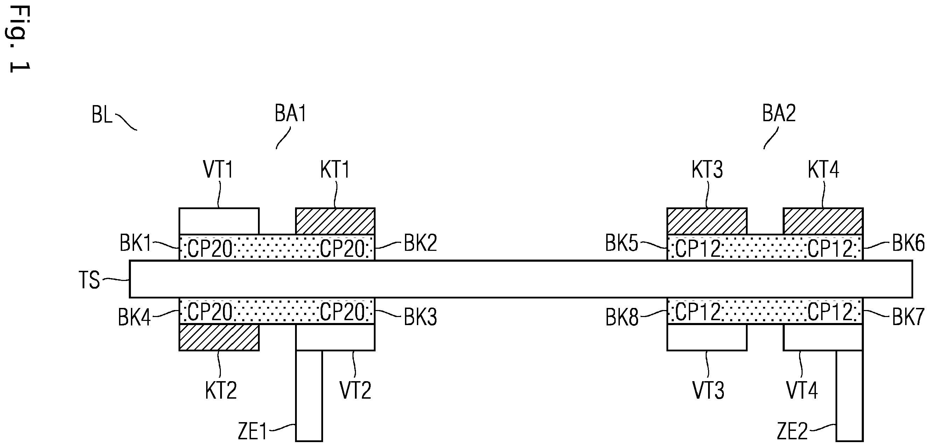

Fig. 1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2014005744 A1
- DE 102009013353